# EUROPEAN PATENT APPLICATION

(11) **EP 0 955 593 A2**
(43) Date of publication of application: **10.11.1999**
(21) Application number: 99108571.3
(22) Date of filing: 06.05.1999
(51) Int. Cl.: G06F 17/50

(54) **Method of estimating layout area of semiconductor integrated circuit, and CAD apparatus therefor**

(30) Priority: 06.05.1998 JP 12316398
(71) Applicant: NEC CORPORATION, Tokyo (JP)
(72) Inventor: Shimada, Yasuo c/o NEC IC Microcomputer Syst.,Ltd., Kawasaki-shi, Kanagawa (JP)
(74) Representative: VOSSIUS & PARTNER

(57) **Abstract**

The degree of complexity of the signal connection relationship of a logic circuit is taken into consideration to improve the precision with which layout area is estimated, thereby making it possible to implement layout and wiring with the minimum required development time and without unwired portions being left in the layout area. Processing includes (S1) inputting connection information relating to a logic circuit; (S2) allocating the number of logic stages of each logic cell; creating data which is a combination of node name, pin attribute, logic cell name and number of logic stages in regard to each pin of the logic cell; (S3) calculating a variance in the overall number of input pins classified by number of logic stages; (S4) calculating a parameter relating to the difference between the number of logic stages of an output pin and the number of logic stages of an input pin; (S5) calculating a parameter relating to the overall number of connected pins of each logic cell; evaluating a calculation equation for estimating layout area from the calculated variance and calculated parameters; and estimating layout area.

## Description

This invention relates to the layout of a semiconductor integrated circuit and, more particularly, to a method of estimating layout area based upon connection information relating to a logic circuit.

There are no clearly defined methods of estimating layout area in the prior art. At present, layout area is estimated empirically, based upon past performance, using the sum of the areas of individual logic cells, the number of pairs (referred to as the "number of pin pairs" below) of output pins and input pins connected, the number of NETs, the number of logic cells used and the number of logic cells per type of logic cell used.

A three-stage layout method, such as set forth in the specification of
JP-A-3-24295, is used widely as the automatic layout method in an automatic layout system. This method is divided into three stages in the signal connection relationship, namely a stage (pre-process) in which logic cells of strong connection strength are gathered together to produce a cluster, a stage (initial-layout process) in which the cluster is initially allocated on a chip, and a stage (layout improvement process) in which a substitution (or rearrangement) improvement is made. The process is implemented in this order. In a case where the process proceeds in accordance with this sequence, the more upstream a stage is, the more the quality of the process result affects the acceptability of the final layout result.

Since the area required for wiring varies greatly depending upon the complexity of the signal connection relationship, it is necessary to take into consideration the circuit arrangement of the logic circuits, namely the signal connection relationship and connection strength, before beginning layout and wiring.

If a chip size having a satisfactory cell layout area and wiring area is not selected, unwired portions will remain after layout and wiring. In such case it is necessary to enlarge chip area and perform layout and wiring again from the start until unwired portions no longer remain or to re-design the circuit per se and perform layout and wiring again from the start. In either case, the result is an increase in time required for development.

Accordingly, if wiring passes near the vicinity of a cell row in which small logic cells are gathered, it is necessary for wiring to be detoured or to insert a feed-thru cell that is exclusively for thru-wiring. This increases the number of blocks and number of tracks. An improvement is disclosed in the specification of Japanese Patent KOKAI Publication JP-A-3-242953. Specifically, use is made of an evaluation function, which takes wiring complexity into account, to average the number of pins between logic cell groups, the number of wires capable of being passed over a logic cell and the average area on logic cells, thereby preventing small logic cells from concentrating locally and minimizing feed-thru.

Whereas recent technological progress has made it possible to fit a large-scale logic circuit on a single chip, the time for implementing a single layout and wiring operation is lengthened. Implementing layout and wiring a number of times lengthens development time markedly.

If a cell layout area or wiring area is provided with too much margin, it is easy to carry out layout and wiring that is free of unwired portions but one consequence is high manufacturing cost due to an increase in chip size.

In the course of intense investigation toward the present invention there have been various problems encountered.

With the current method of estimating layout empirically, no consideration at all is given to the circuit arrangement of logic circuits. Consequently, the possibility that unwired portions and needless cell layout areas and wiring areas will occur after the implementation of layout and wiring is high. In order to implement layout and wiring with the minimal required development time and without unwired portions being left remaining in a layout area, it is vital to take the circuit arrangement of logic circuits into account so as to improve and optimize the precision with which layout area is estimated.

A first problem is that whereas the conventional layout estimation method in which automatic layout and wiring is not performed makes it possible to estimate layout area at the circuit design stage, unwired portions and needless cell layout areas and wiring areas tend to occur after the implementation of layout and wiring. As a result, chip area is changed and layout and wiring is executed a number of times, thereby lengthening development time.

The reason for the above is as follows: When layout area is estimated, cell use rate and the number of pin pairs are obtained for the entire chip and no consideration is given to the connection relationship of the individual logic cells. This means that it is not possible to judge whether the minimum necessary cell layout area and wiring area are satisfied also locally.

A second problem is that the conventional layout estimation method in which automatic layout and wiring is performed is such that automatic layout and wiring must be executed a number of times in order to confirm that the minimum required cell layout area and wiring area are available.

The reason for the above is as follows: When unwired portions occur, it is easy to judge that the cell layout area or wiring area is inadequate. However, whether or not these areas are needlessly large can only be judged based upon whether or not unwired portions have occurred in a case where wiring has been laid out on a chip of smaller size. This makes it necessary to implement automatic layout and wiring a very large number of times.

A third problem is that the conventional layout estimation method in which automatic layout and wiring is performed is such that estimation at the circuit design phase is very difficult.

The reason for the above is that whereas layout cannot be implemented unless a layout-capable environment is established and a circuit capable of being laid out is completed, very often these conditions are not met before the final stage of circuit design.

Accordingly, an object of the present invention is to take circuit arrangement of logic circuits into consideration and improve the precision with which layout area is estimated, thereby making it possible to implement layout and wiring with the minimum required development time and without unwired portions being left in the layout area.

Further objects of the present invention will become apparent in the entire disclosure.

According to a first aspect of the present invention, the foregoing object is attained by providing a method of estimating layout area of a semiconductor integrated circuit designed by storing logic cells of a logic circuit used in a mask layout pattern in a cell library as layout-pattern information, and having a host computer of a CAD apparatus execute layout and wiring and artwork-pattern generation of a group of the logic cells extracted from the cell library.

The method comprises the steps of:
(a) creating, from connection information relating to the logic circuit using means for allocating logic stage counts of respective ones of the logic cells, data obtained by combining node name, pin attribute, logic cell name and logic stage count for each input and output pin of the logic cell;
(b) calculating a variance in ratios of numbers of input pins to overall number of input pins for each (i.e., classified by) logic stage count;
(c) calculating a parameter relating to a difference between logic stage counts of the output pin and the input pin;
(d) calculating a parameter relating to overall number of connected pins for each logic cell;
(e) predicting wiring complexity, at execution of layout and wiring by automatic layout, based upon said parameters relating to the variance, the difference between the logic stage counts and the overall number of connected pins, respectively; and estimating, based upon the predicted wiring complexity, layout area that is devoid of unwired portions.

The allocation of the logic stage counts includes the steps of:
(a) extracting a combination of data of each of the node name, pin attribute and logic cell name from the connection information;
(b) retrieving node names, which correspond to external input pins, regarding input pins of the respective logic cells;
(c) provisionally adopting, as a first stage of a logic stage count, the logic cell to which a retrieved input pin belongs, and retrieving the input pins of other logic cells connected to the node name of the output pin of this logic cell;
(d) provisionally adopting a value, which is obtained by adding one to the logic stage count of the output pin, as the logic stage count of the logic cell to which the newly retrieved input pin belongs, and retrieving, in regard to input pins of each of the logic cells, the node name of an output pin of the logic cell for which the logic stage count has been newly decided;
(e) repeating the foregoing steps until all node names of output pins, which are object of retrieval, of the logic cell become the external output pins; and
(f) if a redundantly retrieved logic cell name spans a plurality of (each) of the logic stage counts, allocating the maximum logic stage count as the final logic stage count of this logic cell, and creating, in regard to all pins, data in which the node name, pin attribute, logic cell name and logic stage count constitute a set.

The step of calculating the variance includes the steps of:
(a) inputting data to which the logic stage counts have been allocated;
(b) sorting the combined data by the logic stage count;
(c) totalizing the number of input pins for each logic stage count and calculating the ratio of each number of input pins to overall number of input pins; and
(d) calculating a variance value in the ratios of the numbers of input pins with respect to the logic stage count, and adopting this variance value as a parameter representing complexity of a signal connection relationship.

The step of calculating the parameter relating to the difference between logic stage counts includes the steps of:
(a) inputting data to which the logic stage counts have been allocated;
(b) sorting the data by the node names;
(c) calculating, in regard to each input pin having the same node name, a stage-count difference, which represents difference between a logic stage count of a logic cell to which the output pin belongs and a logic stage count of a logic cell to which the input pin belongs;
(d) totalizing the number of input pins for each number of stage-count differences and calculating the ratios of these number of input pins; and
(e) weighting the ratio of the number of input pins of each number of stage-count differences in accordance with an increase in the number of stage-count differences, followed by calculating a value obtained by successively subtracting the weighted ratio value from the ratio value for a stage-count difference of one, and adopting this value as a parameter representing complexity of a signal connection relationship.

The step of calculating the parameter relating to the overall number of connected pins includes the steps of:
(a) inputting data to which the logic stage counts have been allocated;
(b) sorting the data by the node names;
(c) calculating the total of the number of input and output pins connected for each node and creating data in which the total is diminished by one;
(d) retrieving the data in regard to the node names of all input/output pins of the logic cell, summing the data to calculate the total of the number of input/output pins connected to the single logic cell, and
(e) performing this operation for all logic cells; performing classification by the total of the number of input/output pins connected per logic cell, dividing the total of the number of connected pins into several intervals, totalizing the number of logic cells in each of these intervals and calculating the ratio of the number of logic cells to the overall number of logic cells; and
(f) weighting the ratio of the number of logic cells in each interval, classified by number of connected pins, in accordance with an increase in the number of connected pins, calculating the total of the weighted ratios and adopting the total as a parameter representing complexity of a signal connection relationship.

According to a second aspect of the present invention, there is provided a method of estimating layout area of a semiconductor integrated circuit designed by storing logic cells of a logic circuit used in a mask layout pattern in a cell library as layout-pattern information, and having a host computer of a CAD apparatus execute layout and wiring and artwork-pattern generation of a group of the logic cells extracted from the cell library.

The method comprises the steps of:
(a) extracting logic stage counts of respective ones of the logic cells from connection information relating to the logic circuit;
(b) totalizing overall number of input pins of the logic cells that belong to the same logic stage count;
(c) calculating, as a parameter representing complexity of a signal connection relationship, a variance value in ratios with respect to the overall number of input pins for each logic stage count; and
(d) calculating layout area using results obtained by said extracting, totalizing and calculating steps.

According to a third aspect of the present invention, there is provided a method of estimating layout area of a semiconductor integrated circuit designed by storing logic cells of a logic circuit used in a mask layout pattern in a cell library as layout-pattern information, and having a host computer of a CAD apparatus execute layout and wiring and artwork-pattern generation of a group of the logic cells extracted from the cell library.

The method comprises the steps of:
(a) extracting logic stage counts of respective ones of the logic cells from connection information relating to the logic circuit;
(b) calculating, in regard to all of the input pins, a stage-count difference, which represents the difference between a logic stage count of a logic cell to which the output pin belongs and a logic stage count of a logic cell to which an input pin connected to the output pin belongs;
(c) for the stage-count differences, performing weighting in dependence upon a value obtained by dividing the number of input pins of each stage-count difference by the number of stage-count differences regarding the value of overall number of input pins;
(d) calculating, as a parameter representing complexity of a signal connection relationship, a value obtained by successively subtracting the weighted value from the value for a stage-count difference of one; and
(e) calculating layout area.

According to a fourth aspect of the present invention, there is provided a method of estimating layout area of a semiconductor integrated circuit designed by storing logic cells of a logic circuit used in a mask layout pattern in a cell library as layout-pattern information, and having a host computer of a CAD apparatus execute layout and wiring and artwork-pattern generation of a group of the logic cells extracted from the cell library.

The method comprises the steps of:
(a) totalizing overall number of connected pins connected to one of the logic cells, based upon connection information relating to the logic circuit;
(b) for the number of connected pins, weighting a value, which is obtained by dividing the number of the logic cells by the overall number of logic cells for each number of connected pins, in accordance with an increase in the number of connected pins, and
(c) calculating the sum total of the weighted values as a parameter representing complexity of a signal connection relationship; and calculating layout area.

The method is applied to estimation of the layout area at any hierarchy and at all hierarchies of the logic circuit.

According to a fifth aspect of the present invention, there is provided a CAD apparatus for a semiconductor integrated circuit designed by storing logic cells of a logic circuit used in a mask layout pattern in a cell library as layout-pattern information, and having a host computer execute layout and wiring and artwork-pattern generation of a group of the logic cells extracted from the cell library.

The apparatus comprises:
(a) allocation means for allocating logic stage counts of respective ones of the logic cells, the allocation means creating, from connection information relating to the logic circuit, data obtained by combining node name, pin attribute, logic cell name and logic stage count for each pin of the logic cell;
(b) first calculation means for calculating a variance in ratios of numbers of input pins to overall number of input pins obtained by logic stage count;
(c) second calculation means for calculating a parameter relating to a difference between logic stage count of the output pin and logic stage count of the input pin; and
(d) third calculation means for calculating a parameter relating to overall number of connected pins for each logic cell; wherein layout area is estimated by the first, second and third calculation means.

Other features and advantages of the present invention will be apparent from the following description taken in conjunction with the accompanying drawings, in which like reference characters designate the same or similar parts throughout the figures thereof.
Fig. 1 is a diagram showing an overview of an embodiment of a CAD apparatus which executes a method of estimating layout area according to the present invention;
Fig. 2 is a flowchart illustrating an embodiment of a method of estimating layout area according to the present invention;
Fig. 3 is a flowchart of means for allocating numbers of logic stages of logic cells;
Fig. 4 is a flowchart of means for calculating a variance in number of input pins by number of logic stages;
Fig. 5 is a flowchart of means for calculating the difference between the number of logic stages of an input pin and the number of logic stages of an output pin;
Fig. 6 is a flowchart of means for calculating a parameter relating to the overall number of connected pins;
Fig. 7 is a block diagram showing an example of a complicated (irregular) circuit;
Fig. 8 is a diagram showing an example of data to which numbers of logic stages have been allocated;
Fig. 9 is a diagram showing an example of calculation of overall number of input pins by number of logic stages;
Fig. 10 is a diagram showing an example of calculation of the difference between numbers of logic stages;
Fig. 11 is a diagram showing an example of calculation of a parameter relating to the difference between the number of logic stages of an input pin and the number of logic stages of an output pin;
Fig. 12 is a diagram showing an example of calculation of number of connected pins;
Fig. 13 is a diagram showing number of pins connected to one logic cell, and numbers of logic cells by overall number of connected pins;
Fig. 14 is a diagram showing an example of calculation of a parameter relating to overall number of connected pins of each logic cell;
Fig. 15 is a block diagram showing an example of a simple (regular) circuit;
Fig. 16 is a diagram showing an example of comparison between logic cells used in a complicated circuit and logic cells used in a simple circuit;
Fig. 17 is a diagram showing an example of a comparison between number of pin pairs and overall area of logic cells of a complicated circuit and number of pin pairs and overall area of logic cells of a simple circuit;
Fig. 18 is a diagram showing an example of a comparison between layout estimation of a complicated circuit and that of a simple circuit;
Fig. 19 is a diagram showing an example of the layout of a complicated (irregular) circuit; and
Fig. 20 is a diagram showing an example of the layout of a simple (regular) circuit.

Before describing an embodiment of the present invention in detail, the gist of the invention will beset forth. Specifically, because parameters representing circuit arrangement (structure) are extracted from the connection information of a logic circuit, it is possible to take into account the sum total of the areas of cells used, the number of pin pairs, the number of NETs, the number of logic cells and, moreover, the complexity of the signal connection relationship between logic cells at implementation of layout and wiring, the latter being a problem heretofore because complexity cannot be determined merely from the number of logic cells per type of logic cell used. This makes it possible to estimate the optimum layout area, thereby preventing the occurrence of unwired portions at the time of layout and wiring.

A preferred embodiment of the present invention will now be described.

In general, a semiconductor integrated circuit is designed by storing logic cells of a logic circuit used in a mask layout pattern in a cell library of a CAD (Computer Aided Design) apparatus beforehand as layout-pattern information, and having a host computer execute layout and wiring and artwork-pattern generation of a group of the logic cells extracted from the cell library. In the present invention, layout area is estimated using the CAD apparatus.

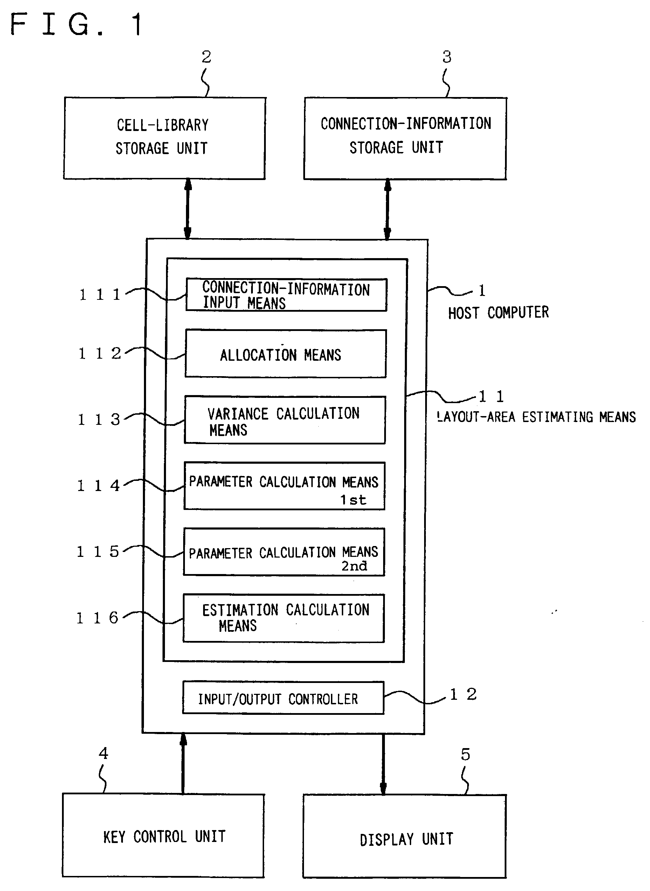

With reference to Fig. 1, which shows the configuration of an embodiment of a CAD apparatus for implementing the layout area estimation method of the present invention, it will be understood that the CAD apparatus includes a host computer 1, a cell-library storage unit 2, a connection-information storage unit 3, a key control unit 4 and a display unit 5.

The host computer 1 has layout-area estimating means 11 according to the present invention, and an input/output controller 12 associated with the key control unit 4 and display unit 5.

The layout-area estimating means 11 is a program comprising connection-information input means 111, allocation means 112 for allocating the number of logic stages of logic cells (the number of logic stages of a logic cell shall also be referred to simply as the "logic stage count" below), variance calculation means 113 for calculating variance in the overall number of input pins, parameter calculation means 114 for calculating a parameter relating to the difference between numbers of logic stages, parameter calculation means 115 for calculating a parameter relating to the overall number of connected pins, and calculation means 116 for estimating layout area.

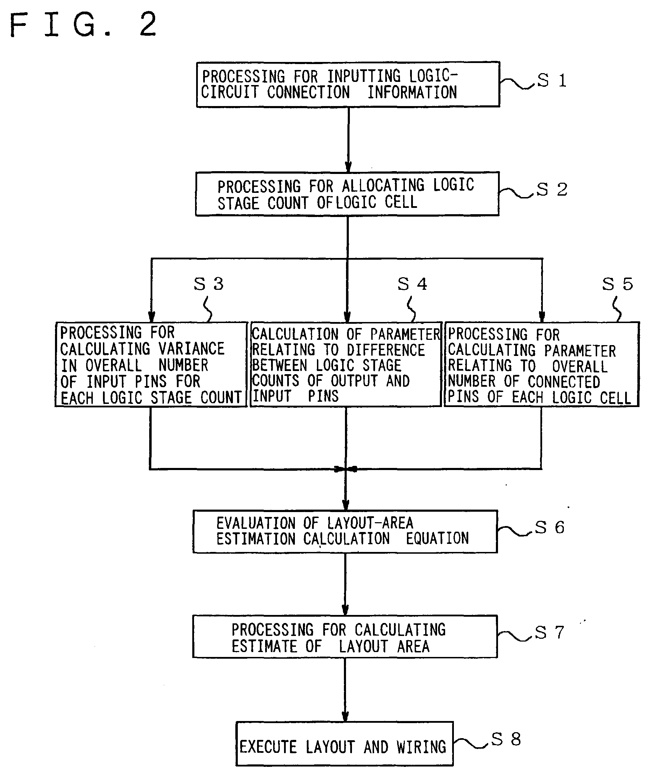

Fig. 2 is a flowchart illustrating an embodiment of a method of estimating layout area using the layout-area estimating means 11 according to the present invention. The method includes processing S1 for inputting connection information relating to a logic circuit, processing S2 for allocating the logic stage count of each logic cell from the entered connection information; processing S3 for calculating, for each logic stage count, a variance in the overall number of input pins in the connection information; processing S4 for calculating a parameter relating to the difference between a number of logic stages (logic stage count) of an output pin and a number of logic stage (logic stage count) of an input pin, wherein these input and output pins are connected at the same node in the connection information, processing S5 for calculating a connected-pin parameter from the overall number of connected pins for each logic cell in the connection information, and processing S6 for obtaining layout area from the variance, the parameter relating to the difference between the logic stage count of an output pin and the logic stage count of an input pin, and the connected-pin parameter.

More specifically, the means 111, 112, 113, 114, 115 and 116 in Fig. 1 correspond to the processing steps S1, S2, S3, S4, S5, S5 and S7.

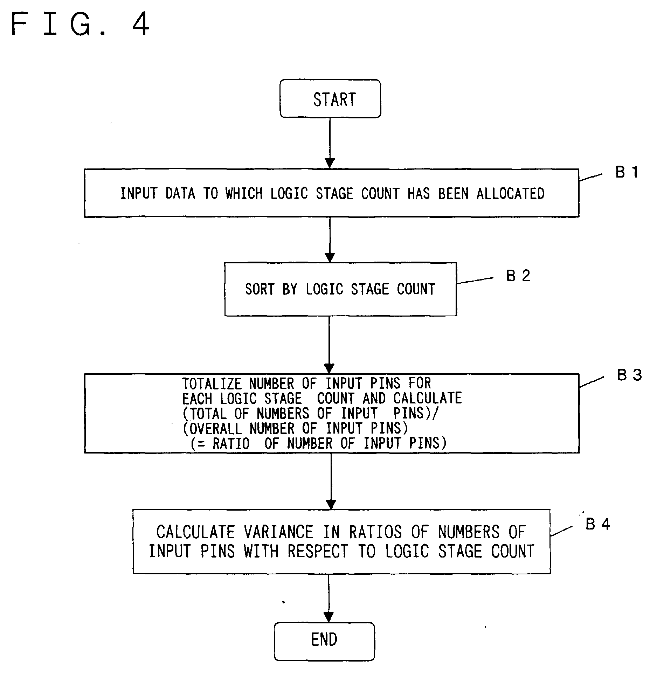

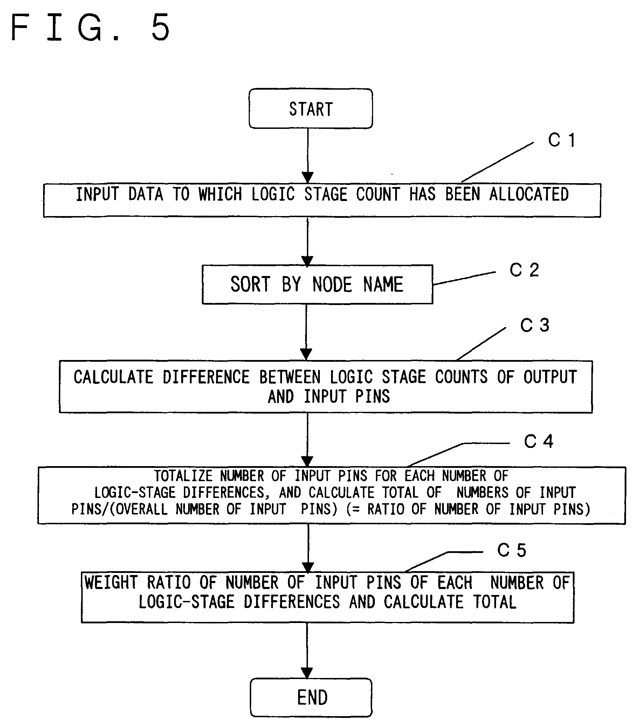

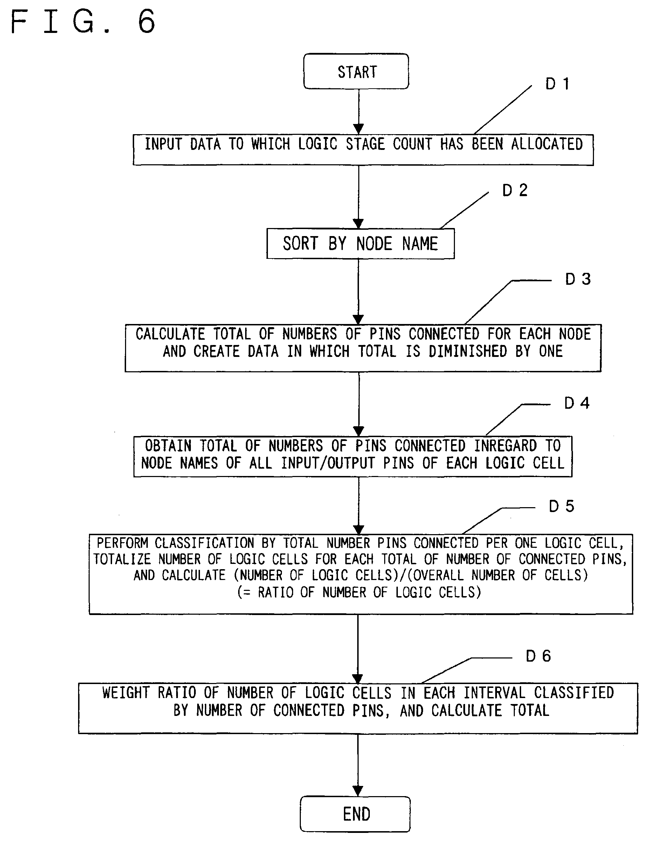

The operation of this embodiment will now be described in detail with reference to Figs. 1 and 2 as well as Fig. 3, which is a flowchart of the means for allocating the number of logic stages of logic cells, Fig. 4, which is a flowchart of the means for calculating the variance in number of input pins by logic stage count, Fig. 5, which is a flowchart of the means for calculating the difference between the logic stage count of an input pin and the logic stage count of an output pin, and Fig. 6, which is a flowchart of the calculation means for calculating the parameter relating to the overall number of connected pins.

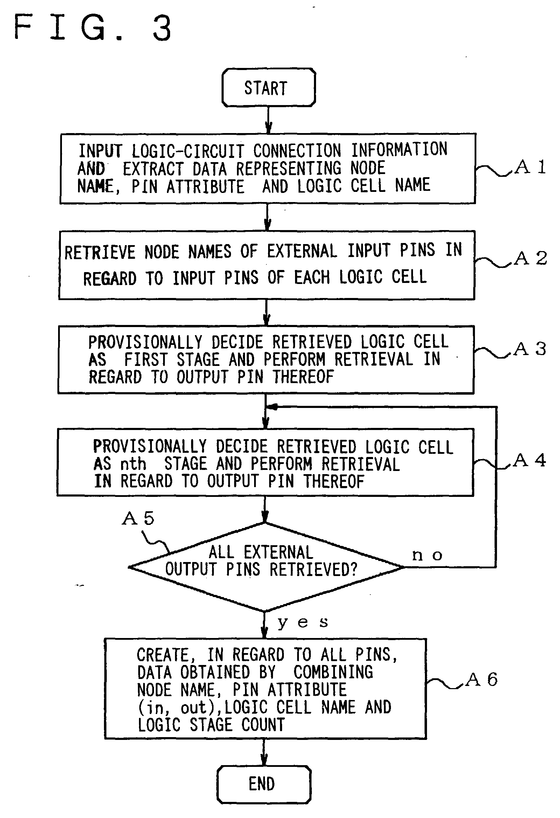

The allocation means (processing) (112 in Fig. 1 and S2 in Fig. 2) for allocating the logic stage counts of logic cells extracts (step A1 in Fig.3) a combination of data representing node name, pin attribute and logic cell name from connection information that has been entered by the logic circuit connection-information input means (processing) (111 in Fig.1 and S1 in Fig.2) and retrieves node names, which correspond to external input pins, in regard to input pins of each of the logic cell to which a retrieved input pin belongs and then retrieves the input pins of other logic cells connected to the node name of the output pin of this logic cell (step A3 in Fig. 3).

The allocation means provisionally adopts, as a first stage of a logic stage count, a logic cell to which a retrieved input pin belongs and then retrieves the input pins of other logic cells connected to the node name of the output pin of this logic cell (step A3 in Fig. 3).

The allocation means provisionally adopts a value, which is obtained by adding 1 to the logic stage count of an output pin, as the logic stage count of a logic cell to which a newly retrieved input pin belongs, and then retrieves, in regard to input pins of each of the logic cells, the node name of an output pin of the logic cell for which the logic stage count has been newly decided (step A4 in Fig. 3).

The allocation means repeats the above-described operation until all node names of retrieved output pins of logic cells become external output pins, i.e., until these output pins are no longer connected to input pins of a logic cell (step A5 in Fig. 3). Multiple-input logic cells are retrieved redundantly (duplicatedly). Therefore, in a case where the same logic cell name spans each of (i.e., a plurality of) the logic stage counts, the maximum logic stage count is allocated as the final logic stage count of this logic cell.

Thus, the allocation means creates, in regard to all pins, data obtained by combining node name, pin attribute (in, out), logic cell name and number of logic stages (step A6 in Fig. 3).

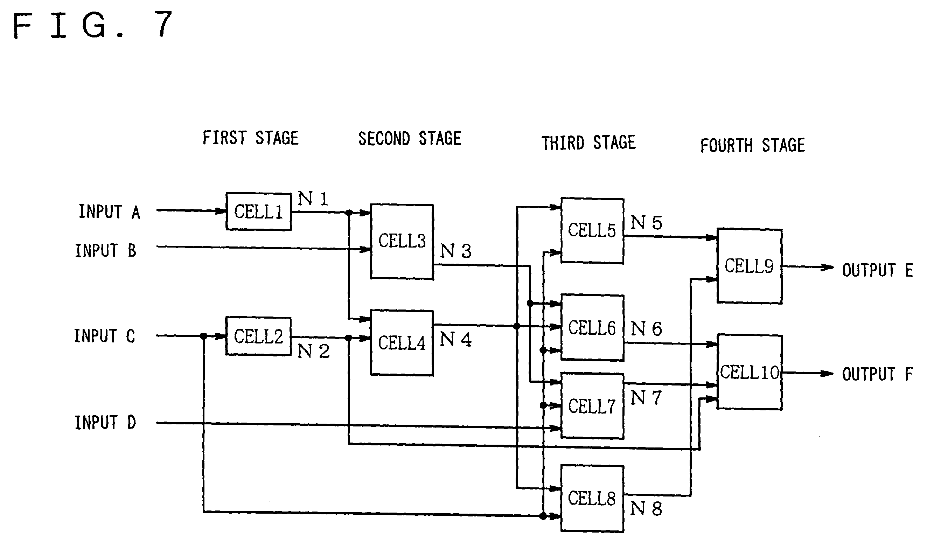

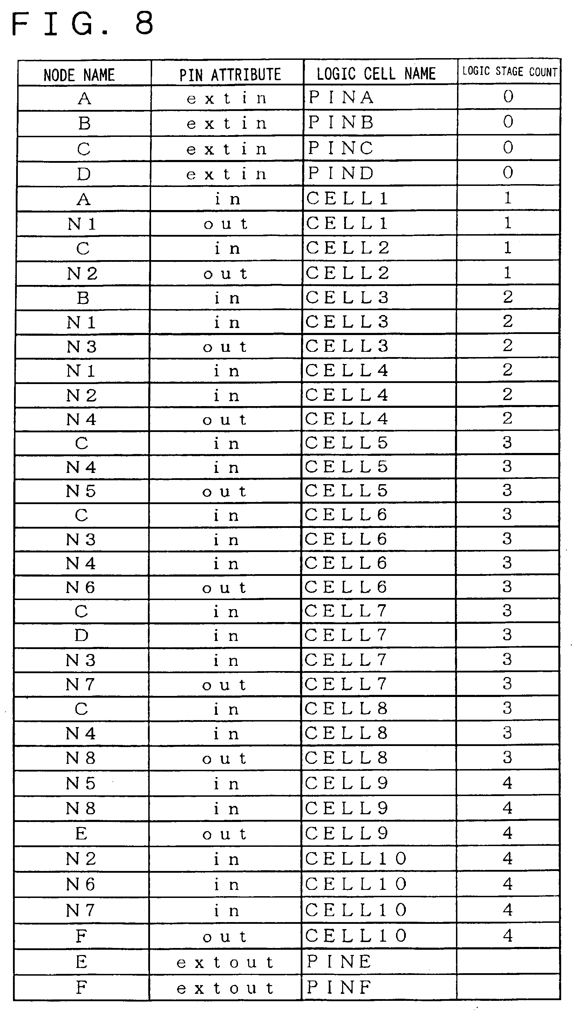

The flow set forth above will now be described in conformity with an actual circuit. Reference will be had to Fig. 7, which is a block diagram showing an example of a circuit having a complicated (irregular) signal connection relationship, and to Fig. 8, which is a diagram showing an example of data to which logic stage counts have been allocated. The allocation means 112 (processing) (112 in Fig. 1 and S2 in Fig. 2) for allocating the logic stage count of logic cells inputs connection information concerning a logic circuit having a complicated signal connection relationship, extracts a combination of data representing node name, pin attribute and logic cell name from the connection information, retrieves the node names A, B, C, D of external input pins, namely pin attribute "extin" and logic cell names PIN A, PIN B, PIN C, PIN D, in regard to the node names of input pins of the logic cells, and provisionally decides that CELL 1, CELL 2, CELL 3, CELL 5, CELL 6, CELL 7 and CELL 8 as the first stage. It should be noted that when retrieval of number of stages (the logical stage count) is finished for all inputs in a certain logic cell, the logic stage count of this logic cell is finalized (i.e., is no longer provisional).

By way of example, the logic cell name of node name A whose pin attribute is "extin" is PIN A and the number of logic stages (the stage count) is 0. Though the logic cell name CELL 1 to which the pin attribute "in" of the pin connected to node A belongs is provisionally adopted as being the first stage of the number of logic stages, this cell has only one input. Accordingly, retrieval ends here and the fact that this is the first stage of the number of logic stages is finalized. Similarly, it is determined that CELL 2 is the first stage of the logic stage count. The remaining cells CELL 3, CELL 5, CELL 6, CELL 7 and CELL 8 have a plurality of inputs and, hence, retrieval is not yet finished. The logic stage counts, therefore, are still provisional.

Next, logic cells directly connected to the logic cells CELL 1 and CELL 2, whose logic stage counts have been finalized, are retrieved.

Input pins (pin attribute "in") of other logic cells connected to the node name N1 of the pin attribute "out" of the output pin of CELL 1 are retrieved (step A3 in Fig. 3).

Values obtained by adding 1 to the logic stage count of the preceding stage (logic stage count 1 of CELL 1 + 1 = 2, and logic stage count 1 of CELL 2 + 1 = 2; therefore, two is the logic stage count of CELL 4; logic stage count 1 of CELL 2 + 1 = 2; therefore, two is the logic stage count of CELL 10) are provisionally adopted as the logic stage counts of logic cells CELL 3, CELL 4 and CELL 10 to which the newly retrieved input pins "in" connected to the node name N1 belong. However, since CELL 3 has two inputs and these are N1 and input B, retrieval ends here and the fact that this is the second stage of the logic stage count is finalized. Similarly, CELL 4 also has two inputs and these are N1 and N2; hence, the fact that this is the second stage of the logic stage count is finalized. CELL 10 has three inputs, among which two have not yet been retrieved. Accordingly, it is provisionally decided that the logic stage count is two.

Next, retrieval is performed in regard to the input pins of logic cells connected to the node names N3, N4 of the output pins "out" of the logic cells CELL 3, CELL 4 for which the logic stage counts have been newly decided.

Values obtained by adding 1 to the logic stage count of the preceding stage (logic stage count 2 of CELL 3 + 1 = 3; therefore, three is the provisional logic stage count of CELL 6 and CELL 7; logic stage count 2 of CELL 4 + 1 = 3; therefore, three is the provisional logic stage count of CELL 5, CELL 6 and CELL 8) are adopted as the logic stage counts of logic cells CELL 6 and CELL 7 to which the newly retrieved input pins "in" connected to the node name N3 belong and as the logic stage counts of logic cells CELL 5, CELL 6 and CELL 8 to which the newly retrieved input pins "in" connected to the node name N4 belong. Among these cells, however, CELL 5 has two inputs and these are N4 and input C; hence, retrieval ends here and the fact that this is the third stage of the logic stage count is finalized. Similarly, CELL 6 has three inputs and these are N3, N4 and input C for which the logic stage counts have been finalized; hence, the fact that CELL 6 also is the third logic stage of the logic stage count is finalized. Similarly, the fact that CELL 7 and CELL 8 also are the third stage of the logic stage count is finalized.

Next, retrieval is performed in regard to the input pins of logic cells connected to the node names N5, N6, N7 and N8 of the output pins "out" of the logic cells CELL 5, CELL 6, CELL 7 and CELL 8 for which the logic stage counts have been newly decided.

Values obtained by adding 1 to the logic stage count of the output pins (logic stage count 3 of CELLs 4 to 8 + 1 = 4; therefore, four is the logic stage count of CELL 9 and CELL 10) are adopted as the logic stage count of logic cell CELL 9 to which the newly retrieved input pin "in" connected to the node name N5 belongs, the logic stage count of logic cell CELL 10 to which the input pin "in" connected to the node name N6 belongs, the logic stage count of logic cell CELL 10 to which the input pin "in" connected to the node name N7 belongs and the logic stage count of logic cell CELL 9 to which the input pin "in" connected to the node name N8 belongs. Among these cells, however, CELL 9 has two inputs and these are N5 and N8; hence, retrieval ends here and the fact that this is the fourth stage of the logic stage count is finalized. Similarly, CELL 10 has three inputs and these are N6, N7 and N2 for which the logic stage counts have been finalized; hence, the fact that CELL 10 also is the fourth logic stage of the logic stage count is finalized.

The node names E and F of the output pins "out" of logic cells CELL 9 and CELL 10 for which the logic stage count has been decided anew are connected to external output pins, namely pins whose pin attributes are "extout", the logic cell names whereof are PIN E and PIN F.

As mentioned above, the above operation is repeated until there are no longer connections to input pins "in" of logic cells. The node names E and F of the output pins of connected logic cells are external output pin and these are not connected to logic cells. Retrieval, therefore, is terminated.

Since the node name of the input pins of logic cells is retrieved, the number of multiple-input logic cells retrieved is equivalent to the number of input pins. However, the maximum logic stage count is taken as the final logic stage count of this logic cell. In other words, though the provisional logic stage count of CELL 10 is two when node N2 is retrieved, the logic stage count is eventually finalized at four, as stated. Fig. 8 illustrates that this logic stage count has been allocated to the data representing node name, pin attribute and logic cell name.

The variance calculation means (processing) (113 in Fig. 1 and S3 in Fig. 2) for calculating a variance in overall number of input pins by logic stage count receives as an input (step B1 in Fig. 4) the data to which the logic stage counts shown in Fig. 8 have been allocated and sorts data, which has been collected into a single set, by each of the logic stage counts 0, 1, 2, 3 and 4 (step B2 in Fig. 4).

When the number of input pins are totalized for each of the logic stage counts 0, 1, 2, 3 and 4, we obtain the following results: For logic stages the count of which is 1, the total for the pin attribute "in" is 2 because the number of input pins is 1 for node name A and 1 for node name C; for logic stages the count of which is 2, the total for the pin attribute "in" is 4 because the number of input pins is 1 for each of node names B and N2 and 2 for node name N1; for logic stages the count of which is 3, the total for the pin attribute "in" is 10 because the number of input pins is 4 for node name C, 3 for node name N4, 2 for node name N3 and 1 for node name D; and for logic stages the count of which is 4, the total of the pin attribute "in" is 5 because the number of input pins is 1 for node name N5, 1 for node name N8, 1 for node name N2, 1 for node name N6 and 1 for node name N7.

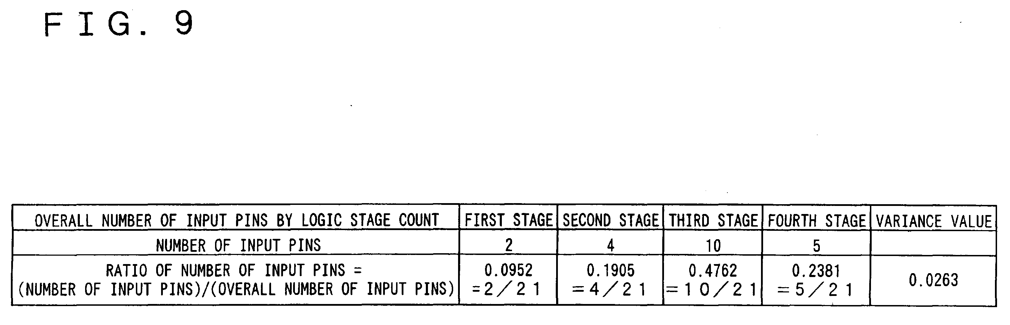

Accordingly, if the ratios of the numbers of input pins are calculated hereafter from values obtained by dividing the total of the number of input pins for each logic stage count by the overall number 21 of input pins, we obtain the following: (2/21) = 0.0952 as the ratio in case of logic stages the count of which is 1; (4/21) = 0.1905 as the ratio in case of logic stages the count of which is 2; (10/21) = 0.4762 as the ratio in case of logic stages the count of which is 3; and (5/21) = 0.2381 as the ratio in case of logic stages the count of which is 4. These results are summarized in Fig. 9.

If the variance in the ratios of numbers of input pins with respect to the logic stage count is calculated, we obtain 0.0263. This value is adopted as a parameter representing the complexity of the signal connection relationship.

Thus, as described above, data to which the logic stage counts shown in Fig. 8 have been allocated is accepted as an input, the data is sorted by the logic stage count, the number of input pins is totalized for each logic stage count, the ratios of the numbers of input pins are calculated, a variance in the ratios of the numbers of input pins with respect to the logic stage counts is calculated, and the calculated variance is adopted as a parameter representing the complexity of the signal connection relationship.

Next, the parameter calculation means (processing) (114 in Fig. 1 and step S4 in Fig. 2) for calculating the difference between logic stage count of output pins and the logic stage count of input pins accepts as an input the data to which the logic stage counts shown in Fig. 8 have been allocated and sorts the data by node name.

For each input pin at the same node name, the parameter calculation means 114 calculates the difference between the logic stage count of the logic cells to which the output pin belongs and the logic stage count of the logic cells to which the input pin belongs. This difference between the logic stage counts is referred to as the "stage-count difference".

By way of example, when the data to which the logic stage counts shown in Fig. 8 is applied as an input and data is sorted by node names A to F and node names N1 to N8, at least one input pin of CELL 1, CELL 2 of the first stage, at least one input pin of CELL 3, CELL 4 of the second stage, at least one input pin of CELL 5, CELL 6, CELL 7, CELL 8 of the third stage and at least one input pin of CELL 9, CELL 10 of the fourth stage is connected to the external input pins A, B, C, D or to an output pin of the preceding stage. The stage-count difference is one, therefore, and the total of the number of input pins relating to this stage-count difference of one is 14.

At least one input pin of CELL 3 of the second stage is connected to the external input pin B by being passed through the first stage, and therefore the stage-count difference is two. The total of the number of input pins relating to this stage-count difference of two is one.

At least one input pin of CELL 5, CELL 6, CELL 7, CELL 8 of the third stage is connected to the external input pins C, D or to the output pin of the stage before last, and therefore the stage-count difference is three. The total of the number of input pins relating to this stage-count difference of three is six.

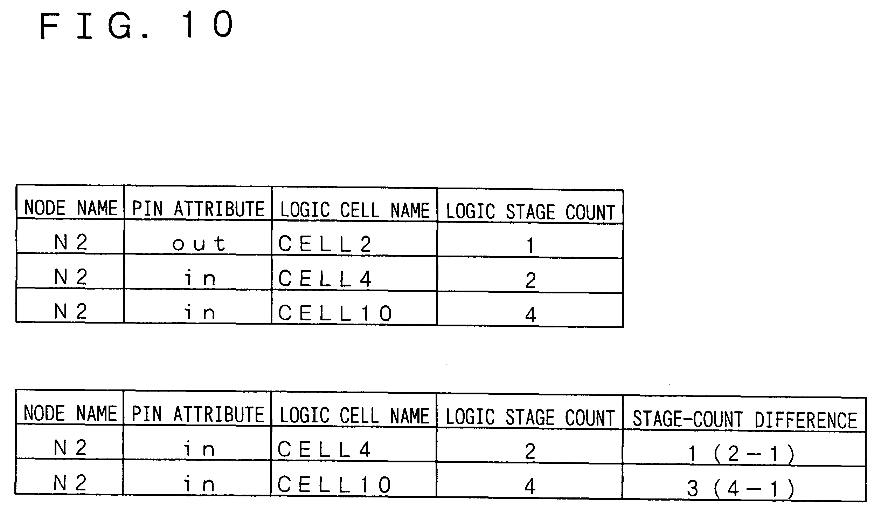

This will be described in greater detail with reference to Fig. 10, which shows an example of the calculation of stage-count differences. Take node N2 as an example. The logic stage count of output node N2 of CELL 2 is one and node N2 is connected to CELL 4 and CELL 10. From Fig. 8, therefore, the logic stage counts are two and four, respectively. Accordingly, for at least one input pin (node N2) of CELL 2, we have stage-count difference = 2 - 1 = 1, and for at least one input pin (node N2) of CELL 10, we have stage-count difference = 4 - 1 = 3.

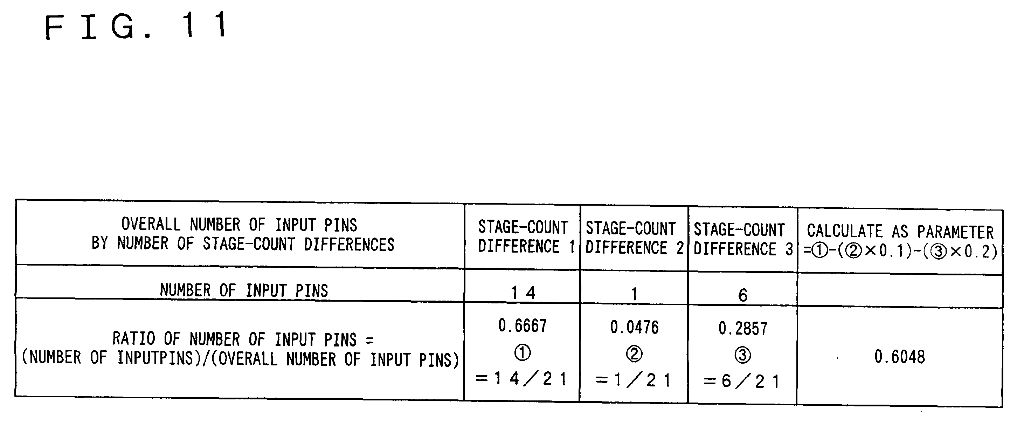

Fig. 11 illustrates an example of calculation of the stage-count difference parameter between input and output pins. In regard to each input pin at the same node name, the difference (the stage-count difference) between the logic stage count of the logic cells to which the output pin belongs and the logic stage count of the logic cells to which the input pin belongs is calculated, as mentioned above, the number of input pins is totalized for each number of stage-count differences (the totals are 14 for a stage-count difference of 1, 1 for a stage-count difference of 2 and 6 for a stage-count difference of 3), and ratios of the number of input pins to the overall number of input/output pins (= 21) for each of these stage-count differences are calculated. The results are as follows: (14/21) = 0.6667 as the ratio for the stage-count difference of one, (1/21) = 0.04776 as the ratio for the stage-count difference of two, and (6/21) = 0.2857 as the ratio for the stage-count difference of three.

If a value calculated as a parameter is to be obtained from these numerical values, we have (stage-count difference of one: 0.6667) - [(stage-count difference of two: 0.0476) × 0.1} - [(stage-count difference of three: 0.2857) × 0.2)], and therefore 0.6048 is adopted as the parameter sought.

The ratio with regard to the number of input pins of each number of stage-count differences is weighted in accordance with an increase in the number of stage-count differences (the ratio for a case where the number of logic-stage differences = 1 is used as is, the ratio for a case where the number of stage-count differences = 2 is multiplied by 0.1, and the ratio for a case where the number of stage-count differences = 3 is multiplied by 0.2), a value obtained by successively subtracting each weighted value from the value for the case where the number of logic-stage difference is equal to one is calculated and this value is adopted as a parameter representing the complexity of the signal connection relationship. Namely the value (ratio) at the logic-stage difference of 1 is successively diminished by subtracting therefrom weighted values (ratios).

Next the parameter calculation means (115 in Fig. 1, step S5 in Fig. 2) for calculating the overall number of connected pins of each logic cell accepts as an input the data to which the logic stage counts have been allocated (step D1 in Fig. 6) and sorts the data by node name (step D2 in Fig. 6).

The parameter calculation means 115 calculates the total of the number of connected pins on a per-node basis and creates data in which this total is diminished (subtracted) by one (its own pin) (step D3 in Fig. 6). The parameter calculation means 115 retrieves the above-described data in regard to the node names of all input/output pins of a logic cell and sums the data to calculate the total of the number of pins connected to one logic cell.

This operation is carried out for all logic cells (step D4 in Fig. 6). The parameter calculation means 115 performs classification by the total of the number of connected pins per logic cell, divides this total of the number of connected pins into several intervals, totalizes the number of logic cells in each interval and calculates a value (referred to as the "ratio of the number of logic cells" below) obtained by dividing the number of logic cells of each interval by the overall number of logic cells (step D5 in Fig. 6). The ratio of the number of logic cells of each interval classified by number of connected pins is weighted in accordance with an increase in the number of connected pins, the resulting ratios are totaled and the total is adopted as a parameter representing the complexity of the signal connection relationship.

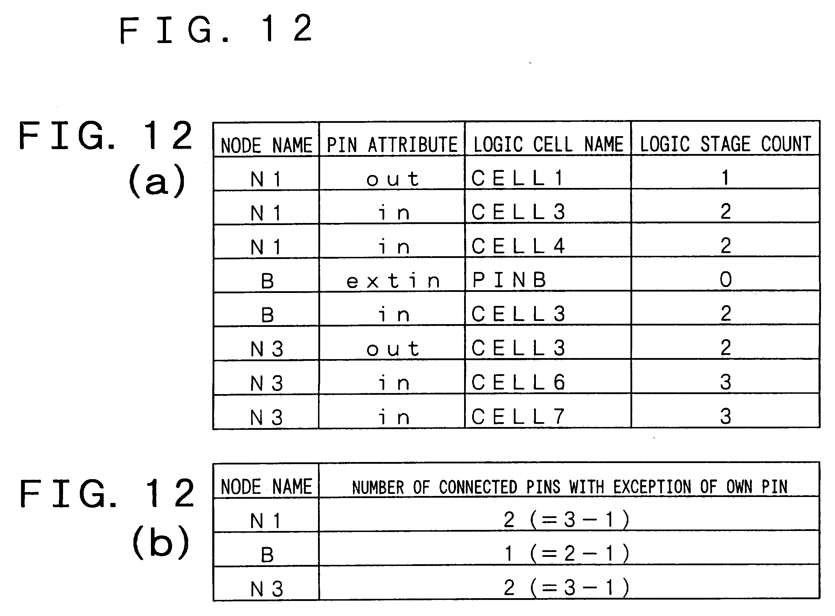

An example will be described with reference to Fig. 12, which illustrates an example of calculation of number of connected pins. The data of Fig. 8 to which the logic stage counts have been allocated is accepted as an input and the data is sorted by node name. In the case of CELL 3, as shown in Fig. 12 (a), three pins, namely "out" of CELL 1, "in" of CELL 4 and its (CELL 3) own pin "in", are connected to node N1, which is one input, while two pins, namely the B pin and its own pin "in", are connected to node B, which is the other input of CELL 3.

Three pins, namely "in" of each of cells CELL 6 and CELL 7 and its own pin "out", are connected to output node N3 of CELL 3. Data in which the total of the number of connected pins is diminished by one (its own pin) is created for each of these nodes, as shown in Fig. 12(b). As a result, the following is obtained: node N1: 3-1 = 2; node B: 2-1 = 1; node N3: 3-1 = 2.

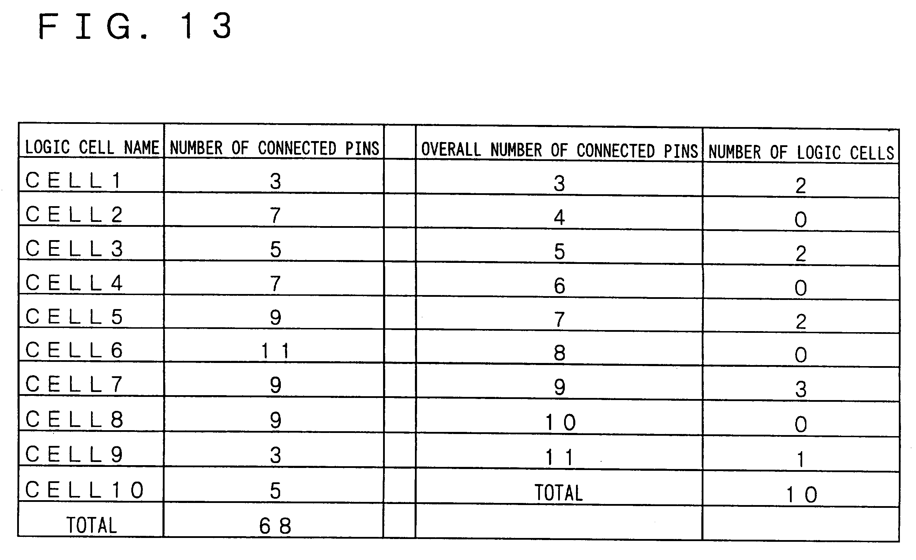

Accordingly, the total of the number of connected pins of CELL 3 is 2 + 1 + 2 = 5. Similarly, the above-mentioned data is retrieved in regard to the node names of all input/output pins of all logic cells and the data is summed to calculate the total of the number of pins connected to one logic cell. Specifically, refer to Fig. 13, which shows number of pins connected to one logic cell, as well as number of logic cells classified by the total of the number of connected pins. It will be appreciated that the total of the number of connected pins inclusive of external input/output pins connected for each logic cell is 68. If this is sorted by overall number of connected pins, the number of logic cells with regard to the overall numbers of connected pins 3 to 11 will be ten.

Thus, as described above, classification is performed by the total of the number of connected pins per logic cell, the total of the number of connected pins is divided into several intervals (or sections) and the number of logic cells is totalized for each interval.

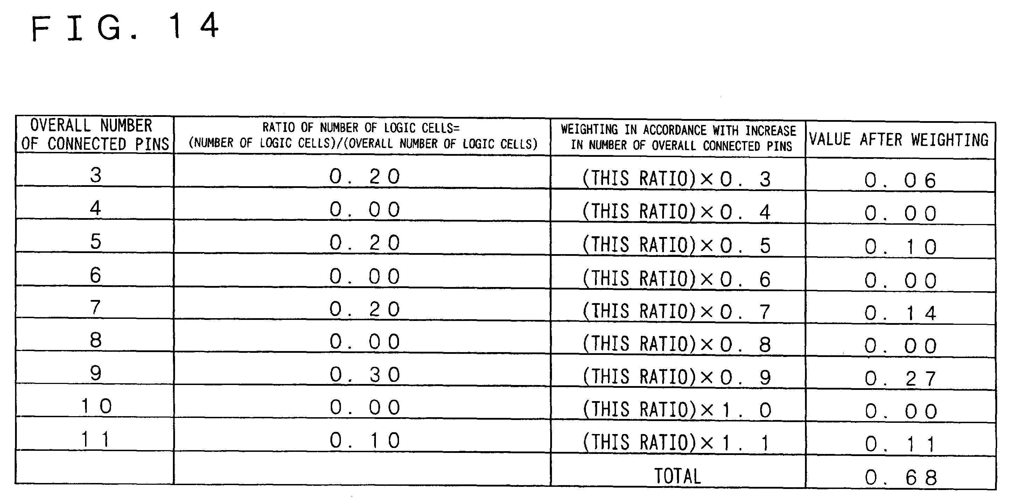

Fig. 14 is a diagram showing an example of calculation of a parameter relating to the overall number of connected pins of each logic cell. After the number of logic cells is totalized for each interval, as described above, a value (referred to as the "ratio of the number of logic cells" below) obtained by dividing the number of logic cells for each interval by the overall number of logic cells is calculated.

By way of example, for three as the overall number of connected pins, the ratio of the number of logic cells is 2/10 = 0.20 if the number of logic cells is two. For four as the overall number of connected pins, the ratio of the number of logic cells is 0/10 = 0.00 if the number of logic cells is zero. For five as the overall number of connected pins, the ratio of the number of logic cells is 2/10 = 0.20 if the number of logic cells is two. The ratios of the numbers of logic cells up to 11 as the overall number of connected pins are obtained in similar fashion.

The ratio of the number of logic cells of each interval classified by number of connected pins is weighted in accordance with an increase in the number of connected pins (here the weighting is changed, e.g., in increments of 0.1 for each increase in the overall number of connected pins). For example, for three as the overall number of connected pins, the ratio 0.20 of the number of logic cells is weighted by 0.3 to give 0.06; for four as the overall number of connected pins, the ratio 0.00 of the number of logic cells is weighted by 0.3 to give 0.00. Values are obtained in similar fashion by weighting the ratios of the numbers of logic cells for overall numbers of connected pins up to 11. When this is done, the total of the values after weighting becomes 0.68.

Thus, as described above, the total of the number of connected pins is calculated for each node and data in which this total is diminished by one (its own pin) is created. This data is retrieved in regard to the node names of all input/output pins of a logic cell and the data is summed to calculate the total of the number of pins connected to one logic cell, this total is classified by the total of the number of connected pins per logic cell, the number of logic cells is totalized for each number of connected pins and the ratio of the number of logic cells is calculated. This ratio of number of logic cells classified by number of connected pins is weighted in accordance with an increase in the number of connected pins, the resulting ratios are totaled and the total is adopted as a parameter representing the complexity of the signal connection relationship.

Next, the layout-area estimating means (processing) (11 in Fig. 1, steps S6, S7 in Fig. 2) calculates the layout area by substituting, into an already determined calculation equation for estimating layout area, the values calculated by the variance calculation means (processing) (113 in Fig. 1 and S3 in Fig. 2) for calculating a variance in the overall number of input pins by logic stage count, the parameter calculation means (processing) (114 in Fig. 1 and step S4 in Fig. 2) for calculating the difference between logic stage counts of output pins and input pins, and the parameter calculation means (processing) (115 in Fig. 1, step S5 in Fig. 2) for calculating the overall number of connected pins of each logic cell.

In other words, at the evaluation (step S6 in Fig. 2) of the calculation equation for estimation of layout area extracted from the past results of layout and wiring implementation, a relation with respect to a layout area for which layout and wiring has been completed is calculated by means separate from the CAD apparatus using, as functions, the variance in overall number of input pins classified by number of logic stages, the parameter relating to the stage-count difference between output and input pins and the parameter relating to the overall number of connected pins of each logic cell.

The layout area and the equation for calculation thereof change if the series or process differ. If the series and process can be specified, therefore, it will be possible to calculate layout area from parameters calculated on the basis of past performance. As a guide, more complicated circuits require more area than simple circuits. Though the evaluation method is the same as the conventional technique based upon cell-use rate and number of pin pairs, the complexity of the circuit is quantified, thereby making possible an estimation that is more precise than that of the prior art.

Next, the layout-area estimating means (processing) (11 in Fig. 1 and S7 in Fig. 2) estimates layout area by substituting, into a layout-area estimating calculation determined beforehand by the conventional technique, The values calculated using the variance calculation means 113 for calculating a variance in overall number of input pins by logic stage count, the parameter calculation means 114 for calculating the difference between the logic stage count of output pins and the logic stage count of input pins and the parameter calculation means 115 for calculating the parameter of the overall number of connected pins of each logic cell.

Next, in implementation of layout and wiring (S8 in Fig. 2) using an automatic layout tool (CAD apparatus), the optimum chip size is selected based upon the estimated layout area, and layout and wiring are implemented using the automatic layout tool.

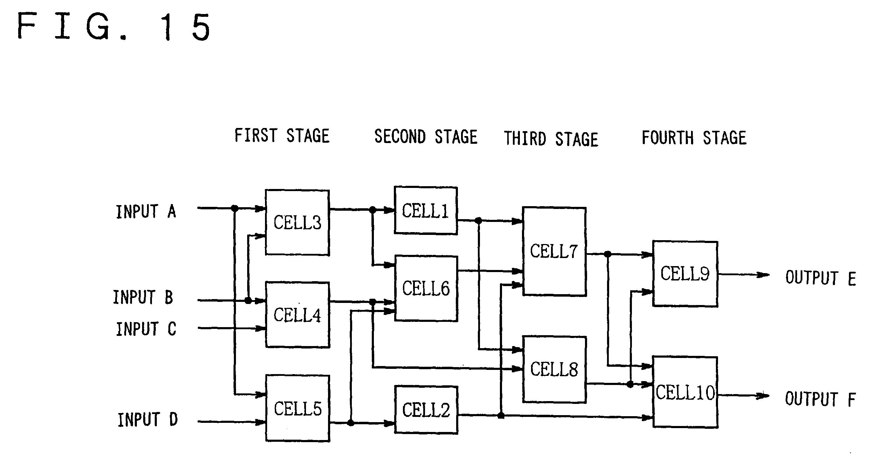

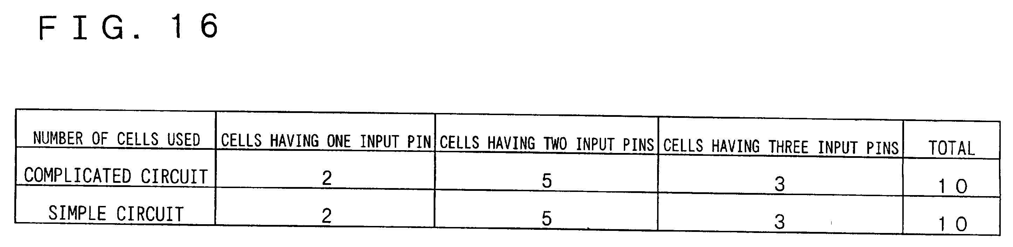

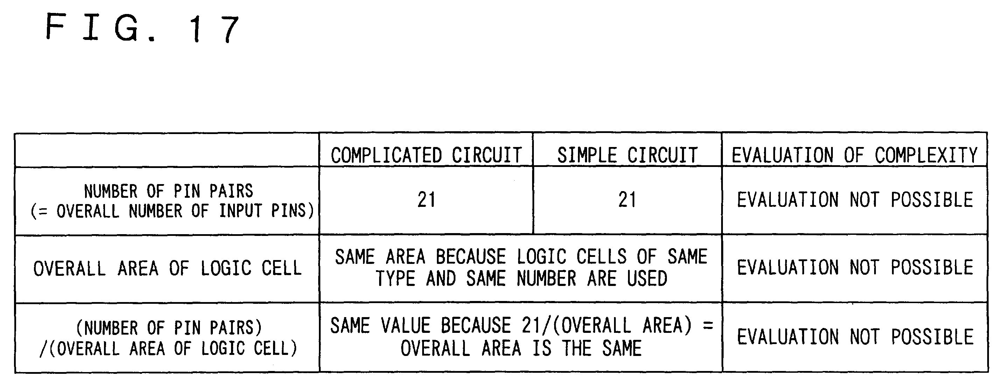

Reference will now be had to Fig. 15 showing an example of a logic circuit for which the signal connection relationship is simple, Fig. 16 showing an example of comparison between number of cells used and number of input pins, and Fig. 17 showing an example of a comparison between number of pin pairs and overall area of logic cells used in estimating layout area according to the prior art. The values are as illustrated. Since no difference can be recognized between the simple circuit and the complicated circuit in terms of the values shown according to the conventional layout estimation method, it can only be judged that the layout areas are the same.

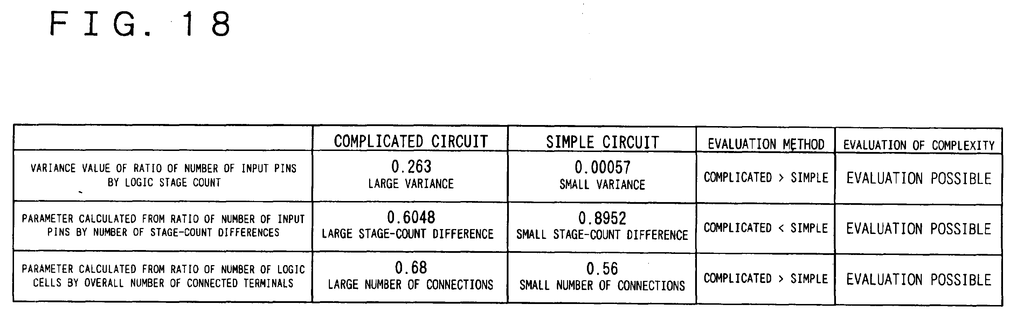

With reference to Fig. 18, which shows an example, to which the present invention has been applied, of a comparison between layout estimation of a complicated circuit and that of a simple circuit, it will be appreciated that the complicated circuit has a larger variance value, a larger stage-count difference and a larger number of connections. This demonstrates that the complicated circuit requires that the layout area be estimated to be larger than that of the simple circuit.

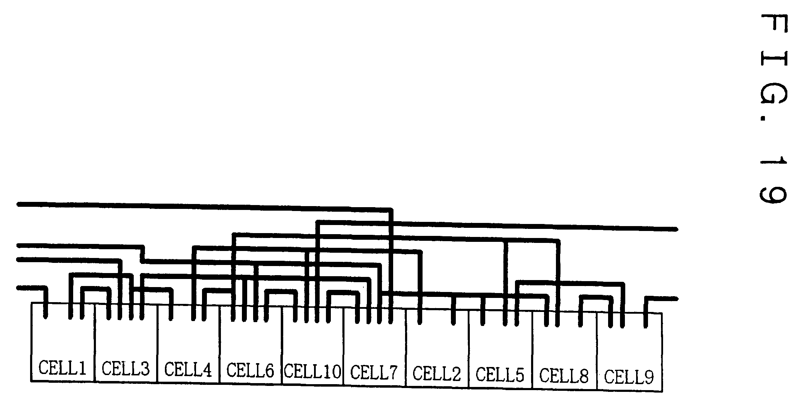

With reference to Fig. 19 showing an example of the layout of a complicated (irregular) circuit, it will be understood that a maximum of seven wiring regions are necessary if the cells are arrayed in one row and wiring is led out from the cells.

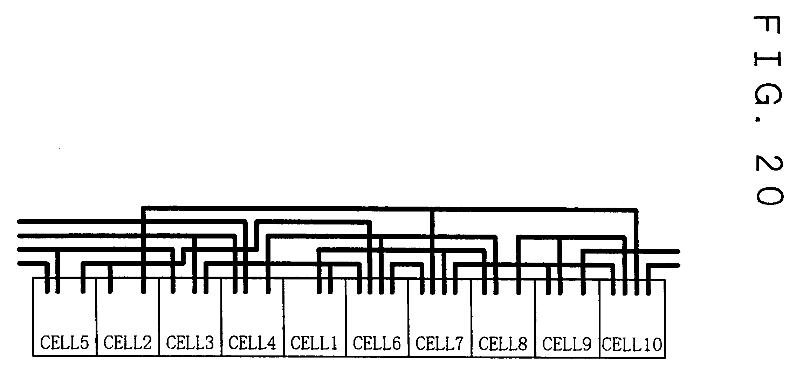

Fig. 20, on the other hand, shows an example of the layout of a simple (regular) circuit. It will be appreciated that a maximum of five wiring regions suffice if the cells are similarly arrayed in one row and wiring is led out from the cells.

Thus, according to the present invention as described above, allocation means allocate logic stage counts of respective ones of logic cells, the allocation means creating, from connection information relating to a logic circuit, data obtained by combining node name, pin attribute, logic cell name and logic stage count for each pin of the logic cell; first calculation means calculates a variance in ratios of numbers of input pins to overall number of input pins obtained by logic stage count; second calculation means calculates a parameter relating to a difference between logic stage count of the output pin and logic stage count of the input pin; and third calculation means calculates a parameter relating to overall number of connected pins for each logic cell; wherein layout area is estimated by the first, second and third calculation means. As a result, layout and wiring that is free of unwired portions can be achieved through a small number of implementations.

Accordingly, a first effect of the present invention is that since layout and wiring can be implemented with the optimum layout area, it is no longer necessary to implement layout and wiring a number of times leaving unwired portions and enlarging the layout area. This makes it possible to suppress an increase in development time.

A second effect of the present invention is that since layout and wiring is implemented with the minimum necessary layout area, it is possible to hold down increases in development cost.

As many apparently widely different embodiments of the present invention can be made without departing from the spirit and scope thereof, it is to be understood that the invention is not limited to the specific embodiments thereof except as defined in the appended claims.

## Claims

1. A method of estimating layout area of a semiconductor integrated circuit designed by storing logic cells of a logic circuit used in a mask layout pattern in a cell library as layout-pattern information, and having a host computer of a CAD apparatus execute layout and wiring and artwork-pattern generation of a group of the logic cells extracted from the cell library, comprising the steps of:
(a) creating, from connection information relating to the logic circuit using means for allocating logic stage counts of respective ones of the logic cells, data obtained by combining node name, pin attribute, logic cell name and logic stage count for each input and output pin of the logic cell;
(b) calculating a variance in ratios of numbers of input pins to overall number of input pins for each logic stage count;
(c) calculating a parameter relating to a difference between logic stage counts of the output pin and the input pin;
(d) calculating a parameter relating to overall number of connected pins for each logic cell;
(e) predicting wiring complexity, at execution of layout and wiring by automatic layout, based upon said parameters that relate to said variance, said difference between the logic stage counts and said overall number of connected pins, respectively; and
(f) estimating, based upon the predicted wiring complexity, layout area that is devoid of unwired portions.

2. The method according to claim 1, wherein said allocation of the logic stage counts includes the steps of:
(a) extracting a combination of data of each of the node name, pin attribute and logic cell name from the connection information;
(b) retrieving node names, which correspond to external input pins, regarding input pins of the respective logic cells;
(c) provisionally adopting, as a first stage of a logic stage count, the logic cell to which a retrieved input pin belongs, and retrieving the input pins of other logic cells connected to the node name of the output pin of this logic cell;
(d) provisionally adopting a value, which is obtained by adding one to the logic stage count of the output pin, as the logic stage count of the logic cell to which the newly retrieved input pin belongs, and retrieving, in regard to input pins of each of the logic cells, the node name of an output pin of the logic cell for which the logic stage count has been newly decided;
(e) repeating the foregoing steps until all node names of output pins, which are object of retrieval, of the logic cell become the external output pins; and
(f) if a redundantly retrieved logic cell name spans a plurality of the logic stage counts, allocating the maximum logic stage count as the final logic stage count of this logic cell, and creating, in regard to all pins, data in which the node name, pin attribute, logic cell name and logic stage count constitute a set.

3. The method according to claim 1 or 2, wherein said step of calculating the variance includes the steps of:
(a) inputting data to which the logic stage counts have been allocated;
(b) sorting the combined data by the logic stage count;
(c) totalizing the number of input pins for each logic stage count and calculating the ratio of each number of input pins to overall number of input pins; and
(d) calculating a variance value in the ratios of the numbers of input pins with respect to the logic stage count, and adopting this variance value as a parameter representing complexity of a signal connection relationship.

4. The method according to claim 1, 2 or 3, wherein said step of calculating the parameter relating to the difference between logic stage counts includes the steps of:
(a) inputting data to which the logic stage counts have been allocated;
(b) sorting the data by the node names;
(c) calculating, in regard to each input pin having the same node name, a stage-count difference, which represents difference between a logic stage count of a logic cell to which the output pin belongs and a logic stage count of a logic cell to which the input pin belongs;
(d) totalizing the number of input pins for each number of stage-count differences and calculating the ratios of these number of input pins; and
(e) weighting the ratio of the number of input pins of each number of stage-count differences in accordance with an increase in the number of stage-count differences, calculating a value obtained by successively subtracting the weighted ratio value from the ratio value for a stage-count difference of one, and adopting this value as a parameter representing complexity of a signal connection relationship.

5. The method according to claim 1, 2, 3 or 4, wherein said step of calculating the parameter relating to the overall number of connected pins includes the steps of:
(a) inputting data to which the logic stage counts have been allocated;
(b) sorting the data by the node names;
(c) calculating the total of the number of input and output pins connected for each node and creating data in which this total is diminished by one;
(d) retrieving said data in regard to the node names of all input/output pins of the logic cell, summing the data to calculate the total of the number of input/output pins connected to the single logic cell, and performing this operation for all logic cells;
(e) performing classification by the total of the number of input/output pins connected per logic cell, dividing the total of the number of connected pins into several intervals, totalizing the number of logic cells in each of these intervals and calculating the ratio of the number of logic cells to the overall number of logic cells; and
(f) weighting the ratio of the number of logic cells in each interval, classified by number of connected pins, in accordance with an increase in the number of connected pins, calculating the total of the weighted ratios and adopting the total as a parameter representing complexity of a signal connection relationship.

6. A method of estimating layout area of a semiconductor integrated circuit designed by storing logic cells of a logic circuit used in a mask layout pattern in a cell library as layout-pattern information, and having a host computer of a CAD apparatus execute layout and wiring and artwork-pattern generation of a group of the logic cells extracted from the cell library, comprising the steps of:
(a) extracting logic stage counts of respective ones of the logic cells from connection information relating to the logic circuit;
(b) totalizing overall number of input pins of the logic cells that belong to the same logic stage count;
(c) calculating, as a parameter representing complexity of a signal connection relationship, a variance value in ratios with respect to the overall number of input pins for each logic stage count; and
(d) calculating layout area using results obtained by said extracting, totalizing and calculating steps.

7. A method of estimating layout area of a semiconductor integrated circuit designed by storing logic cells of a logic circuit used in a mask layout pattern in a cell library as layout-pattern information, and having a host computer of a CAD apparatus execute layout and wiring and artwork-pattern generation of a group of the logic cells extracted from the cell library, comprising the steps of:
(a) extracting logic stage counts of respective ones of the logic cells from connection information relating to the logic circuit;
(b) calculating, in regard to all of the input pins, a stage-count difference, which represents the difference between a logic stage count of a logic cell to which the output pin belongs and a logic stage count of a logic cell to which an input pin connected to said output pin belongs;
(c) for said stage-count differences, performing weighting in dependence upon a value obtained by dividing the number of input pins of each stage-count difference by the number of stage-count differences regarding the value of overall number of input pins;
(d) calculating, as a parameter representing complexity of a signal connection relationship, a value obtained by successively diminishing the value for a stage-count difference that is equal to one; and
(e) calculating layout area.

8. A method of estimating layout area of a semiconductor integrated circuit designed by storing logic cells of a logic circuit used in a mask layout pattern in a cell library as layout-pattern information, and having a host computer of a CAD apparatus execute layout and wiring and artwork-pattern generation of a group of the logic cells extracted from the cell library, comprising the steps of:
(a) totalizing overall number of connected pins connected to one of the logic cells, based upon connection information relating to the logic circuit;
(b) for said number of connected pins, weighting a value, which is obtained by dividing the number of the logic cells by the overall number of logic cells for each number of connected pins, in accordance with an increase in the number of connected pins, and calculating the sum total of the weighted values as a parameter representing complexity of a signal connection relationship; and
(c) calculating layout area.

9. The method according to claim 6, 7 or 8, wherein said method is applied to estimation of the layout area at any hierarchy and at all hierarchies of said logic circuit.

10. A CAD apparatus for a semiconductor integrated circuit designed by storing logic cells of a logic circuit used in a mask layout pattern in a cell library as layout-pattern information, and having a host computer execute layout and wiring and artwork-pattern generation of a group of the logic cells extracted from the cell library, comprising:
(a) allocation means for allocating logic stage counts of respective ones of the logic cells, said allocation means creating, from connection information relating to the logic circuit, data obtained by combining node name, pin attribute, logic cell name and logic stage count for each pin of the logic cell;
(b) first calculation means for calculating a variance in ratios of numbers of input pins to overall number of input pins obtained by logic stage count;
(c) second calculation means for calculating a parameter relating to a difference between logic stage count of the output pin and logic stage count of the input pin; and
(d) third calculation means for calculating a parameter relating to overall number of connected pins for each logic cell;
(e) wherein layout area is estimated by said first, second and third calculation means.
